# EUROPEAN PATENT SPECIFICATION

(11) **EP 2 502 265 B1**
(45) Date of publication and mention of the grant of the patent: **14.09.2016**
(21) Application number: 10787569.2
(22) Date of filing: 19.11.2010
(51) Int. Cl.: H01L 21/677, C23C 16/455

(54) **FLOATING WAFER TRACK WITH LATERAL STABILIZATION MECHANISM**
SCHWEBENDE WAFERSPUR MIT SEITLICHEM STABILISIERUNGSMECHANISMUS
PISTE FLOTTANTE DE TRANCHE AVEC MÉCANISME DE STABILISATION LATÉRALE

(30) Priority: 19.11.2009 NL 2003836
(43) Date of publication of application: 26.09.2012
(73) Proprietor: ASM International N.V., 1322 AP Almere (NL)
(72) Inventor: GRANNEMAN, Ernst Hendrik August, NL-1217 AD Hilversum (NL)
(74) Representative: V.O.
(86) International application number: PCT/NL2010/050772
(87) International publication number: WO 2011/062490

(56) References cited:
- WO-A1-87/04853
- WO-A1-2009/142487
- WO-A2-00/42638
- US-A- 4 874 273

## Description

### Field of the invention

The present invention relates to the field of semiconductor processing, and more in particular to a method of floatingly supporting and processing a train of substantially rectangular wafers.

### Background

During semiconductor device fabrication semiconductor substrates or wafers may be subjected to a variety different treatments such as, for example, deposition and annealing. An apparatus for performing these treatments may be configured to process the substrates in continuous succession, which may offer improved throughput rates relative to alternative batch systems. Accordingly, said apparatus may feature a linear track or path along which the substrates may be transported while being processed.

To simplify the design of such an apparatus, and to reduce the need for periodic maintenance, substrates may preferably be transported along the track by means of a 'contactless' method, i.e. a method that does not employ mechanical components that physically contact the substrates to propel them in a desired direction. One such method may involve the use of two gas bearings, an upper and a lower one, between which substrates may be floatingly accommodated while being transported and processed. A problem with substrates thus supported is that they may become destabilized by the gas flows necessary to maintain the gas bearings. Consequently, the substrates may start to stray from their predetermined trajectory towards the edges of the gas bearings, and/or undergo angular displacements. In this regard it is relevant that some processing apparatus, such as for example spatial atomic layer deposition apparatus, may be particularly suited to process rectangular substrates. Due to their constant width (seen along their length) rectangular substrates may make better use of the processing capacity of the apparatus than for example circular wafers. Rectangular substrates, however, do not possess circular symmetry. Along narrow tracks bounded by lateral walls, which themselves may be favorable for reasons of economic gas flow management, the lack of circular symmetry may cause destabilized substrates to collide with and get stuck between said walls. Generally, substrate-wall contacts are best prevented as they are bound to lead to fracture of the respective, typically fragile substrate and/or congestion of the track. A lateral stabilization mechanism capable of correcting positional aberrations, such as in particular angular deviations, within an operational double gas bearing is therefore desired.

It is an object of the present invention to provide for an apparatus having such a lateral stabilization system, and a method of transporting substrates using such an apparatus.

### Summary of the invention

According to one aspect of the invention, a method is provided. The method may include providing a substrate processing apparatus. The apparatus may comprise a process tunnel, including a lower tunnel wall, an upper tunnel wall, and two lateral tunnel walls. Together the tunnel walls may bound a process tunnel space that extends in a transport direction of the process tunnel, and that is configured to accommodate at least one substantially planar substrate that is oriented parallel to the upper and lower tunnel walls. The apparatus may further comprise a plurality of gas injection channels, provided in both the lower and the upper tunnel wall. The gas injection channels in the lower tunnel wall may be configured to provide a lower gas bearing, while the gas injection channels in the upper tunnel wall may be configured to provide an upper gas bearing. Said gas bearings may be configured to floatingly support and accommodate the substrate between them. Each of the lateral tunnel walls may also comprise a plurality of gas exhaust channels, wherein said gas exhaust channels may be spaced apart in the transport direction. A gas exhaust channel density, i.e. a number of gas exhaust channels in said lateral tunnel walls per unit of tunnel length, which unit of tunnel length is equal to a length of the substrate, is in the range of 5-20. The method may also comprise providing a substantially rectangular substrate and transporting it through the process tunnel.

The apparatus according to the present invention may be employed to facilitate a variety of semiconductor treatments. In one embodiment, for example, the apparatus may be set up as a spatial atomic layer deposition apparatus featuring at least one depositing gas bearing, which bearing may comprise a number of spatially separated reactive materials or precursors. To this end, gas injection channels in at least one of the lower wall and the upper wall may, viewed in the transport direction, be successively connected to a first precursor gas source, a purge gas source, a second precursor gas source and a purge gas source, so as to create a process tunnel segment that - in use - comprises successive zones including a first precursor gas, a purge gas, a second precursor gas and a purge gas, respectively. In another embodiment, the apparatus may be set up as an annealing station. For this purpose, the gas flows of the gas bearings may be heated to a suitable annealing temperature, at least over a portion of a track along which a substrate may be transported. In yet another embodiment, the apparatus may merely provide for a safe transport environment for substrates.

These and other features and advantages of the invention will be more fully understood from the following detailed description of certain embodiments of the invention, taken together with the accompanying drawings, which are meant to illustrate and not to limit the invention.

### Brief description of the drawings

Fig. 1 is a diagrammatic longitudinal cross-sectional view of a portion of an exemplary embodiment of an atomic layer deposition apparatus according to the present invention;
Fig. 2 is a diagrammatic lateral cross-sectional view of the embodiment of the atomic layer deposition apparatus shown in Fig. 1;
Fig. 3 shows two diagrammatic top views of a substrate disposed between two lateral tunnel walls of a process tunnel, and schematically illustrates two kinds of motional/positional aberration a substrate may exhibit during its passage through the process tunnel of the apparatus shown in Figs. 1 and 2: translational aberration (left) and rotational aberration (right);
Fig. 4 and 5 show graphs illustrating a difference in pressure distribution between two opposing pairs of neighboring gas exhaust channels in case of a translationally decentered substrate;
Fig. 6-8 show graphs illustrating the dependency of a pressure distribution between two neighboring gas exhaust channels within a single longitudinal gas channel on the width of the channel, wherein the center-to-center distance between neighboring gas exhaust channels in the respective graphs is 10 mm, 20 mm and 50 mm;
Fig. 9 is a top view illustration of three physical situations, corresponding to different angular positions of a square substrate within a process tunnel, whose data are compared in the graphs of Figs. 10 and 11;
Fig. 10 is a graph illustrating, for each of the situations shown in Fig. 9, the pressure distribution in a longitudinal gas channel alongside an entire left side of a substrate;
Fig. 11 is a graph illustrating, for each of the situations shown in Fig. 9, the differential pressure distribution along the length of a substrate; and
Fig. 12 is a graph illustrating three pressure distributions in a longitudinal gas channel alongside a substrate that is disposed in an embodiment of a substrate processing apparatus according to the present invention similar to that shown in Figs.1-2, but with additional positioning gas injection channels provided in the upper and lower tunnel walls.

### Detailed description

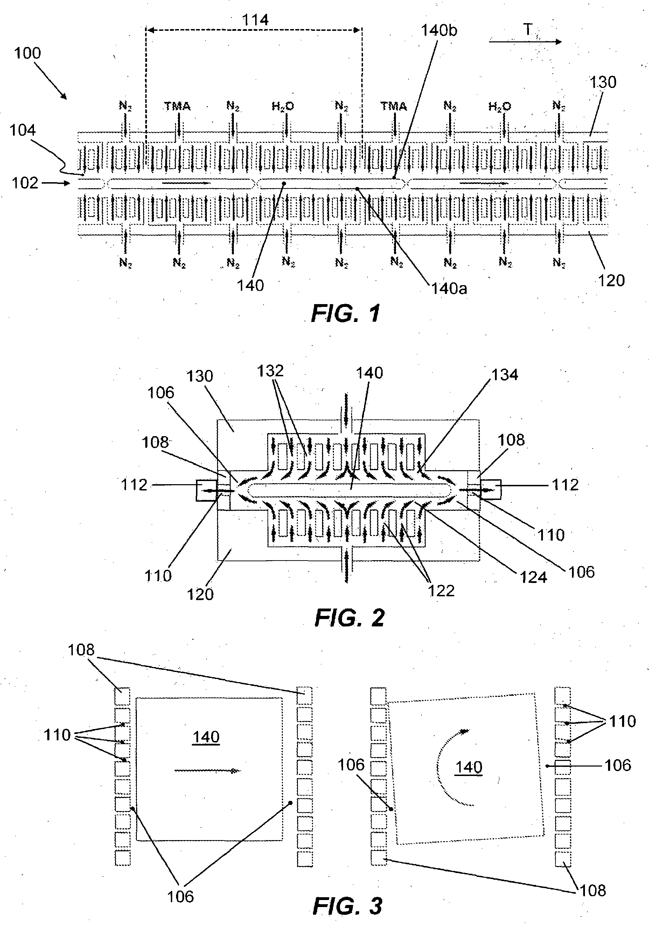

The construction of the apparatus according to the present invention will be described below in general terms. In doing so, reference will be made to the exemplary embodiment shown in Figs. 1 and 2, which is set up as a spatial atomic layer deposition (ALD) apparatus. Fig. 1 is a diagrammatic longitudinal cross-sectional view of a portion of the exemplary ALD apparatus wherein the upper and lower walls of the process tunnel are configured asymmetrically. Fig. 2 is a diagrammatic lateral cross-sectional view of the exemplary atomic layer deposition apparatus shown in Fig. 1.

The disclosed apparatus 100 according to the present invention may include a process tunnel 102 through which a substrate 140, e.g. a silicon wafer, preferably as part of a train of substrates, may be conveyed in a linear manner. That is, the substrate 140 may be inserted into the process tunnel 102 at an entrance thereof to be uni-directionally conveyed to an exit. Alternatively, the process tunnel 102 may have a dead end and the substrate 140 may undergo a bi-directional motion from an entrance of the process tunnel, towards the dead end, and back to the entrance. Such an alternative bi-directional system may be preferred if an apparatus with a relatively small footprint is desired. Although the process tunnel 102 itself may be rectilinear, such need not necessarily be the case.

The process tunnel 102 may include four walls: an upper wall 130, a lower wall 120, and two lateral or side walls 108. The upper wall 130 and the lower wall 120 may be oriented horizontally, mutually parallel and be spaced apart slightly, e.g. 0.5-1 mm, such that a substantially flat or planar substrate 140, having a thickness of for example 0.1-0.3 mm and oriented parallel to the upper and lower walls 130, 120, may be accommodated in between without touching them. The lateral walls 108, which may be oriented substantially vertically and mutually parallel, may interconnect the upper wall 130 and the lower wall 120 at their lateral sides. The lateral walls 108 may be spaced apart by a distance somewhat larger than a width of a substrate 140 to be processed, e.g. its width plus 0.5-3 mm. Accordingly, the walls 108, 120, 130 of the process tunnel 102 may define and bound an elongate process tunnel space 104 having a relatively small volume per unit of tunnel length, and capable of accommodating one or more substrates 140 that are successively arranged in the longitudinal direction of the tunnel.

Both the upper tunnel wall 130 and the lower tunnel wall 120 may be provided with a plurality of gas injection channels 132, 122. The gas injection channels 132, 122 in either wall 130, 120 may be arranged as desired as long as at least a number of them is dispersed across the length of the tunnel 102. Gas injection channels 132, 122 may, for example, be disposed on the corners of an imaginary rectangular grid, e.g. a 25 mm x 25 mm grid, such that gas injection channels are regularly distributed over an entire inner surface of a respective wall, both in the longitudinal and transverse direction thereof.

The gas injection channels 132, 122 may be connected to gas sources, preferably such that gas injection channels in the same tunnel wall 120, 130 *and* at the same longitudinal position thereof are connected to a gas source of a same gas or gas mixture. For ALD-purposes, the gas injection channels 122, 132 in at least one of the lower wall 120 and the upper wall 130 may, viewed in the transport direction T, be successively connected to a first precursor gas source, a purge gas source, a second precursor gas source and a purge gas source, so as to create a process tunnel segment 114 that - in use - will comprise successive (tunnel-wide) gas zones including a first precursor gas, a purge gas, a second precursor gas and a purge gas, respectively. It in understood that one such a tunnel segment 114 corresponds to a single ALD-cycle. Accordingly, multiple tunnel segments 114 may be disposed in succession in the transport direction T to enable the deposition of a film of a desired thickness. Different segments 114 within a process tunnel 102 may, but need not, comprise the same combination of precursors. Differently composed segments 114 may for example be employed to enable the deposition of mixed films.

Whether opposing gas injection channels 122, 132, which share a same longitudinal position of the process tunnel but are situated in opposite tunnel walls 120, 130 are connected to gas sources of the same gas composition may depend on the desired configuration of the apparatus 100. In case double-sided deposition is desired, i.e. ALD treatment of both the upper surface 140b and lower surface 140a of a substrate 140 travelling through the process tunnel 102, opposing gas injection channels 122, 132 may be connected to the same gas source. Alternatively, in case only single-sided deposition is desired, i.e. ALD treatment of merely one of the upper surface 140b and lower surface 140a of a substrate 140 to be processed, gas injection channels 122, 132 in the tunnel wall 120, 130 facing the substrate surface to be treated may be alternatingly connected to a reactive and an inert gas source, while gas injection channels in the other tunnel wall may all be connected to an inert gas source.

In the exemplary embodiment of Figs. 1 and 2, the gas injection channels 132 in the upper wall 130 are successively connected to a trimethylaluminum (Al₂(CH₃)₂, TMA) source, a nitrogen (N₂) source, a water (H₂O) source, and a nitrogen source, so as to form a series of identical tunnel segments 114 suitable for performing aluminum oxide (Al₂O₃) atomic layer deposition cycles. The gas injection channels 122 in the lower tunnel wall 120, in contrast, are all connected to a nitrogen source. Accordingly, the exemplary apparatus 100 is set up to maintain an upper depositing fluid bearing 134 and a lower non-depositing fluid bearing 124, together configured to perform single-sided deposition on a top surface 140b of a passing, floatingly supported substrate 140.

Each of the lateral walls 108 of the process tunnel 102 may, along its entire length or a portion thereof, be provided with a plurality of gas exhaust channels 110. The gas exhaust channels 110 may be spaced apart - preferably equidistantly - in the longitudinal direction of the process tunnel. The distance between two neighboring or successive gas exhaust channels 110 in a same lateral wall 108 may be related to a length of the substrates 140 to be processed. In this text, the 'length' of a rectangular substrate 140 is to be construed as the dimension of the substrate generally extending in the longitudinal direction of the process tunnel 120. For reasons to be clarified below, a lateral wall portion the length of a substrate 140 may preferably always comprise between approximately 5 and 20, and more preferably between 8 and 15, exhaust channels 110. The center-to-center distance between two successive gas exhaust channels 110 may be in the range of approximately 10-30 mm. The longitudinal distance between edges of two neighboring gas exhaust channels 10 may preferably be at least about 75% of said center-to-center distance, which is to say that the gas exhaust channels are relatively 'short' compared to their center-to-center separation distance. The gas exhaust channels 110 may have any suitable shape or size. The exhaust channels 110 in a said lateral wall 108 may further be identical to each other, but need not be. In one embodiment of the apparatus 100, for example, all gas exhaust channels 110 may have a rectangular cross-section having a cross-sectional area of about 1 x 0.5 mm². The 1 mm may correspond to the dimension in the longitudinal direction of the process tunnel 102, whereas the 0.5 mm may correspond to the dimension in the height direction of the process tunnel 102. In other embodiments the exhaust channels 110 may, of course, have different shapes and sizes.

The gas exhaust channels 110 may be connected to and discharge into gas exhaust conduits 112 provided on the outside of the process tunnel 102. In case the apparatus 100 is set up to perform ALD, the exhaust gases may contain quantities of unreacted precursors. Accordingly, it may be undesirable to connect gas exhaust channels 110 associated with mutually different reactive gas zones to the same gas exhaust conduit 112 (which may unintentionally lead to chemical vapor deposition). Different gas exhaust conduits 112 may thus be provided for different precursors.

The general operation of the apparatus 100 may be described as follows. In use, both the gas injection channels 132, 122 in the upper wall 130 and the lower wall 120 inject gas into the process tunnel space 104. Each gas injection channel 122, 132 may inject the gas provided by the gas source to which it is connected. As the apparatus 100 is capable of operating at both atmospheric and non-atmospheric pressures, gas injection may take place at any suitable pressure. However, to render vacuum pumps superfluous, and to prevent any contaminating gas flows from the process tunnel environment into the tunnel space 104 (especially at the substrate entrance and exit sections), the tunnel space may preferably be kept at a pressure slightly above atmospheric pressure. Accordingly, gas injection may take place at a pressure a little above atmospheric pressure, e.g. at an overpressure on the order of 1·10³ Pa. In case a lower pressure is maintained in the gas exhaust conduits 112, for example atmospheric pressure, the gas injected into the tunnel space 104 will naturally flow sideways, transverse to the longitudinal direction of the process tunnel and towards the gas exhaust channels 110 in the side walls 108 that provide access to the exhaust conduits 112.

In case a substrate 140 is present between the upper and lower walls 130, 120, the gas(es) injected into the tunnel space 104 by the gas injection channels 132, 122 in the upper wall 130 may flow sideways between the upper wall and a top surface 140b of the substrate. These lateral gas flows across a top surface 140b of the substrate 140 effectively provide for an upper fluid bearing 134. Likewise, the gas(es) injected into the tunnel space 104 by the gas injection channels 122 in the lower wall 120 will flow sideways between the lower wall and a lower surface 140a of the substrate 140. These lateral gas flows across a bottom surface 140a of the substrate 140 effectively provide for a lower fluid bearing 124. The lower and upper fluid bearings 124, 134 may together encompass and floatingly support the substrate 140.

To deposit a film onto a substrate 140, the substrate may be moved through the process tunnel 102 in the transport direction T. Movement of the substrate 140 may be effected in any suitable way, both by contact and non-contact methods. Non-contact methods are preferred, among other reasons because wearable mechanical parts for driving substrates may typically complicate the design of apparatus and increase the need for maintenance. Contactless methods of propelling a substrate 140 may include propulsion by directed gas streams effected through gas injection channels 122, 132 that are placed at an angle relative to the transport direction T such that the injected gas streams have a tangential component in the transport direction; propulsion by electric forces and/or magnetic forces; propulsion by gravity (which may be effected by inclining the entire process tunnel 120 with respect to the horizontal), and any other suitable method.

Whatever method of driving the substrate 140 is chosen, care must be taken to ensure a suitable substrate transport velocity is effected. In the ALD-apparatus of Fig. 1 and 2, the transport velocity of the substrate 140 is preferably such that, when passing a specific precursor gas zone, a patch of substrate surface area is exposed to the precursor sufficiently long to ensure that it is fully saturated. A longer precursor zone generally allows for a higher transport velocity, and vice versa. Note, however, that the saturation time may depend on the nature of the precursor being used, and on the concentration of the precursor in the respective zone.

As the substrate 140 moves through the process tunnel 102 of Fig. 1 its upper surface 140b is strip-wise subjected to the gases present in each of the successively arranged and traversed gas zones. Provided that the arrangements of the zones and the respective gases are chosen properly, traversal of one tunnel segment 114 may be equivalent to subjecting the substrate 140 to one atomic layer deposition cycle. Since the tunnel 102 may comprise as many segments 114 as desired, a film of arbitrary thickness may be grown on the substrate 140 during its crossing of the tunnel. The linear nature of the process tunnel 102 further enables a continuous stream of substrates 140 to be processed, thus delivering an atomic layer deposition apparatus 100 with an appreciable throughput capacity.

Now that the general operation of the apparatus according to the present invention has been discussed, attention is invited to the lateral stabilization mechanism incorporated into the design thereof.

The lateral stabilization mechanism serves to correct two kinds of motional/positional aberration that may be picked up by substrates 140 travelling through the process tunnel 102: translational and rotational aberrations. A translational aberration concerns the undesired sideways movement of an entire substrate 140 towards one of the lateral walls 108 of the process tunnel 102, and away from the other; see the left drawing in Fig. 3. A rotational aberration concerns the undesired rotation of a substrate 140, causing the longitudinal edges of a rectangular substrate to turn out of alignment with the side walls 108; see the right drawing in Fig. 3.

A problem with these aberrations is that they may lead to contact between a moving substrate 140 and a static side wall 108. Due to the impart of a collision, a substrate 140 may fracture. The fracture may result in debris that may come into contact with subsequent substrates and is likely to cause a pile-up of substrates and congestion of the process tunnel. A rectangular substrate 140 has the additional problem, resulting from its lack of circular symmetry, that rotation may change its effective width. Consequently, a rotationally destabilized rectangular substrate may get stuck or jammed in between the two side walls 108 of the process tunnel 102. Again, a pile-up of substrates crashing into each other may be the result. In either case, the apparatus 100 would have to be shut down for maintenance to allow the process tunnel 102 to be cleared out. Obviously, the fractured substrates, the downtime of the apparatus and the man-hours spent on maintenance represent economical losses that are best prevented by averting any contact between substrates 140 and tunnel walls 108.

To correct both translational and rotational aberrations, a lateral stabilization mechanism may provide for correctional forces in accordance with the arrows drawn in Fig. 3. That is to say, the left-side translational aberration may be rectified by a net force acting on the substrate 140 and pushing it to the right, whereas the anti-clockwise rotation of the substrate may be corrected by a force couple acting to turn the substrate in the clockwise direction. Such corrections are effected by the presently disclosed lateral stabilization mechanism. Constructionally, this lateral stabilization mechanism may be said to comprise two primary 'components': a longitudinal gas channel 106 alongside each of the side walls 108, and a plurality of gas exhaust channels 110 provided in either side wall 108.

As mentioned, the process tunnel 102 may preferably be slightly wider than a substrate 140. As a result, a (narrow) longitudinal gas channel 106 may be present on either lateral side of a centered substrate 140, in between a lateral edge of the substrate and the respective side wall 108 of the process tunnel 102. A longitudinal gas channel 106 may have a good conductance in the longitudinal direction of the process tunnel 102, and may be said to collect the gases that flow sideways across the substrate surfaces 140a, 140b before distributing them to the longitudinally spaced apart gas exhaust channels 110 in the respective adjacent side wall 108. The gas exhaust channels 110 in the lateral walls of the tunnel 102 may serve as flow restrictions, inhibiting the free flow of gas from the process tunnel space 104 into the exhaust conduits 112. Accordingly, pressure may build up *between* adjacent gas exhaust channels 110, while relatively low pressures may occur *at or near* the gas exhaust channels.

Now, when a substrate 140 destabilizes and moves towards a side wall 108 of the tunnel 102 - either entirely due to translation or partially due to rotation - it may 'invade' the longitudinal gas channel 106 originally present along that side wall. The width of longitudinal gas channel 106 may thereby be locally diminished, which in turn may locally obstruct the exhaust of gases from the tunnel space 104 to the gas conduits 112. Consequently, pressures may be built up between successive exhaust channels 110, which pressures may be greatest at the points where the longitudinal gas channel 106 is pinched off most. As the buildup of pressure occurs alongside the longitudinal edge of the substrate, said edge experiences a (distributed) correctional force. Indeed, the correctional force may be largest at the positions of closest approach.

In the case of the translational aberration shown in Fig. 3 (left drawing), the longitudinal gas channel 106 alongside the approached left side wall 108 is pinched off, while the longitudinal gas channel alongside the opposite right side wall is broadened. Accordingly, pressure may be built up on the left side of the wafer, while the pressure on the right side may drop, both effects resulting in a net correctional force on the substrate acting to push it to the right. In the case of the rotational aberration shown in Fig. 3 (right drawing), the pressures developing alongside the lateral edges of the substrate vary in the longitudinal direction, depending on how close a point on a said edge is to the respective side wall 108: the closer, the higher the pressure at said point. As a result of the symmetry of the configuration - including the fact that both side walls are substantially identical and symmetrically opposed to each other - the pressure profiles along both opposite edges of the substrate 140 result in a corrective clockwise force couple.

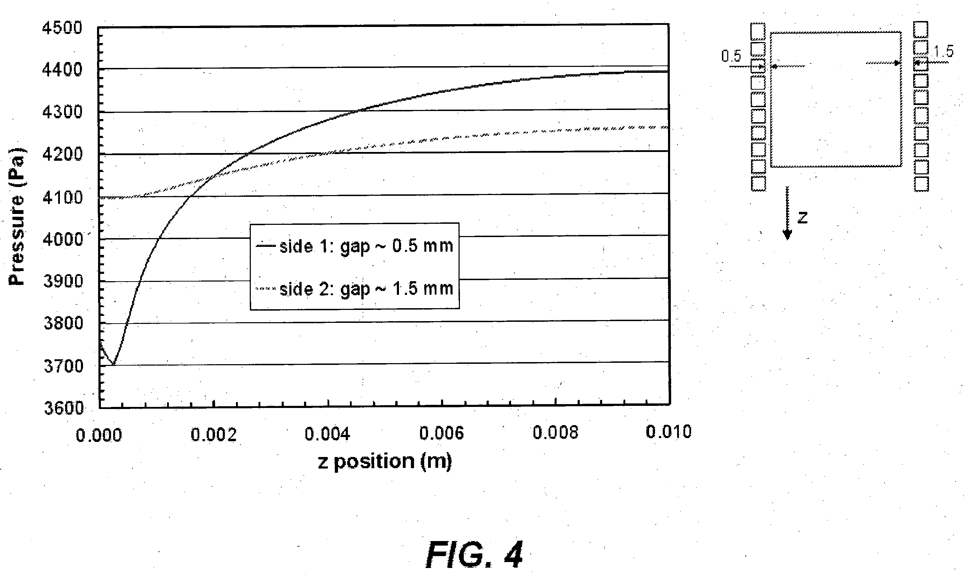

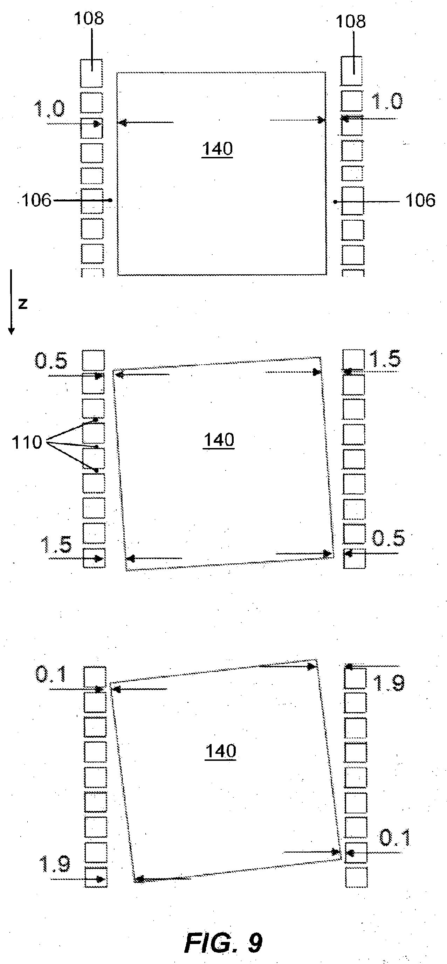

The pressure distributions that may develop when a longitudinal gas channel 106 is pinched off by a substrate 140 may, besides on the local width of the gas channel, depend on a number of other parameters, among which the center-to-center distance between successive gas exhaust channels 110. Both situations shown in Fig. 3 will therefore be illustrated in some more detail. The translational aberration will be illustrated first with reference to Figs. 4-5 and Figs. 6-8, and the rotational aberration will be subsequently illustrated with reference to Figs. 9-11. The graphs shown in these figures have been obtained through fluid dynamics simulations. They serve primarily to illustrate the qualitative behavior of the lateral stabilization mechanism.

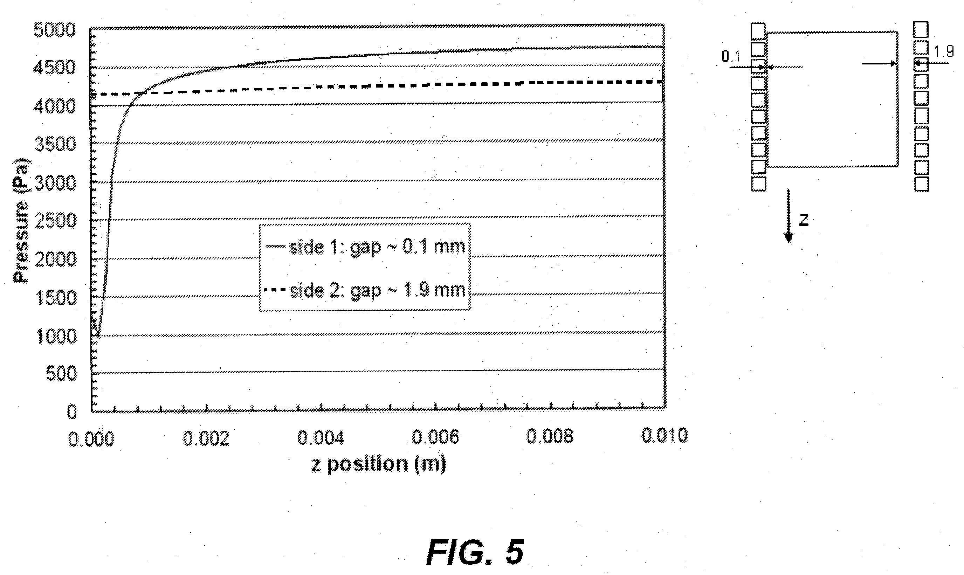

Figs. 4 and 5 illustrate the dependency of a pressure profile on the (uniform) width of longitudinal gas channels 106 alongside a translationally decentered substrate 140. Both figures relate to a situation wherein the center-to-center distance between neighboring gas exhaust channels is 20 mm. The horizontal axis of the depicted graphs thus covers a longitudinal distance from a center of a gas exhaust channel (at 0.000 m) to a point (at 0.010 m) halfway said gas exhaust channel and its neighbor. The factual situation to which a respective graphs pertains is shown in the inset to the right thereof.

In the situation of Fig. 4, the width of the longitudinal gas channel 106 on the left of the substrate 140 has been pinched off to 0.5 mm, while the width of the longitudinal gas channel on the right has broadened to 1.5 mm; the centered position of the substrate 140 would thus corresponds to 1 mm gaps on both sides of the substrate. The graph illustrates the fact that, in the narrow(ed) longitudinal gas channel 106 on the left of the substrate 140, the pressure starts off low at the location of an exhaust channel 110, but increases steeply in the direction of a neighboring exhaust channel. The pressure profile in the wide(ned) longitudinal gas channel 106 on the right of the substrate 140, on the other hand, is significantly less pronounced. The lines in the graph intersect each other at a longitudinal position of about 0.002 m. This means that over the distance 0.000-0.002 m, say at or immediately adjacent longitudinal positions featuring oppositely disposed gas exhaust channels 110, there exists a differential force on the substrate 140 that acts to push it further to the left. However, over the distance 0.002 - 0.010 m, say at longitudinal positions featuring oppositely disposed side wall portions that extend between adjacent gas exhaust channels 110, there exists a differential force on the substrate that acts to push it to the right. Integration of the resulting differential force over the length of the substrate 140 leads to the conclusion that a corrective net force, acting on the substrate to push it to the right, results.

In the situation of Fig. 5, the substrate has moved somewhat further to the left, resulting in gaps of 0.1 and 1.9 mm to the left and right of the substrate, respectively. In the left, narrowed longitudinal gas channel 106 the pressure near an exhaust channel 110 has dropped relative to that shown in the graph of Fig. 4, while the pressure between adjacent gas exhaust channels 110 has increased (note the pressure scale difference between the graphs of Fig. 4 and 5). In the right, broadened longitudinal gas channel 106 on the other hand, the pressure profile has leveled off further. Integration of the resulting differential force over the length of the substrate 140 leads to the conclusion that a corrective net force, acting on the substrate to push it to the right and greater than that for the situation shown in Fig. 4, results. Accordingly, the closer a substrate 140 gets to a side wall 108 of the tunnel 102, the larger the restoring force it experiences.

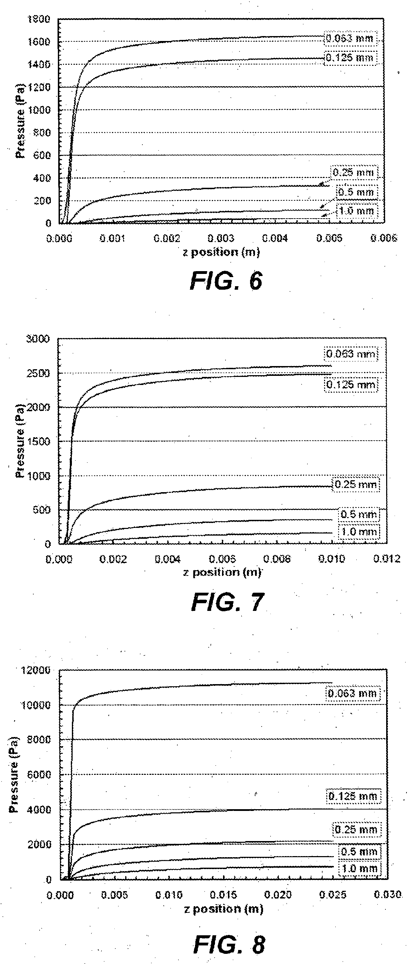

Figs. 6-8 illustrate the dependency of a pressure distribution between neighboring gas exhaust channels 110 within a longitudinal gas channel 106 alongside a substrate 140 on the (uniform) width of said channel. Fig. 6-8 relate to situations wherein the center-to-center distance between adjacent gas exhaust channels is 10 mm, 20 mm and 50 mm respectively. Each figure comprises data for longitudinal channel or gap widths of 1.000 mm, 0.500 mm, 0.250 mm, 0.125 mm and 0.063 mm. The horizontal axes of the depicted graphs again cover a longitudinal distance from a center of a gas exhaust channel 110 (at 0.000 m) to a point halfway said gas exhaust channel and its nearest neighbor.

Individually, Figs. 6-8 all display the same general relation: the narrower the longitudinal gas channel 106, the larger the pressure difference between a location at or immediately near an exhaust channel 110 and a location in between or halfway two adjacent exhaust channels. Seen in conjunction, Figs. 6-8 further illustrate the fact that an increasing center-to-center distance between two neighboring gas exhaust channels further increases the maximum pressure that occurs between them. This fact is corroborated by experiments, which have shown that the center-to-center distance between neighboring gas exhaust channels 110 may even become so large, that the pressures that may build up between them may become too great for a moving substrate to overcome. That is to say, the substrate 140 may be halted. In addition, the pressure troughs occurring immediate near the exhaust channels 110 deepen with increasing channel spacing, and may lead to substrates being sucked against the lateral walls 108. For 160 mm x 160 mm substrates, it has been found that gas exhaust channel center-to-center separation distances between roughly 10 and 30 mm generally provide the desired effect, i.e. sufficient pressure buildup to provide for restoring forces and insufficient pressure buildup to prevent a substrate 140 from passing. These separation distances translate to approximately 5 -20 gas exhaust channels 110 over the length of a substrate 140.

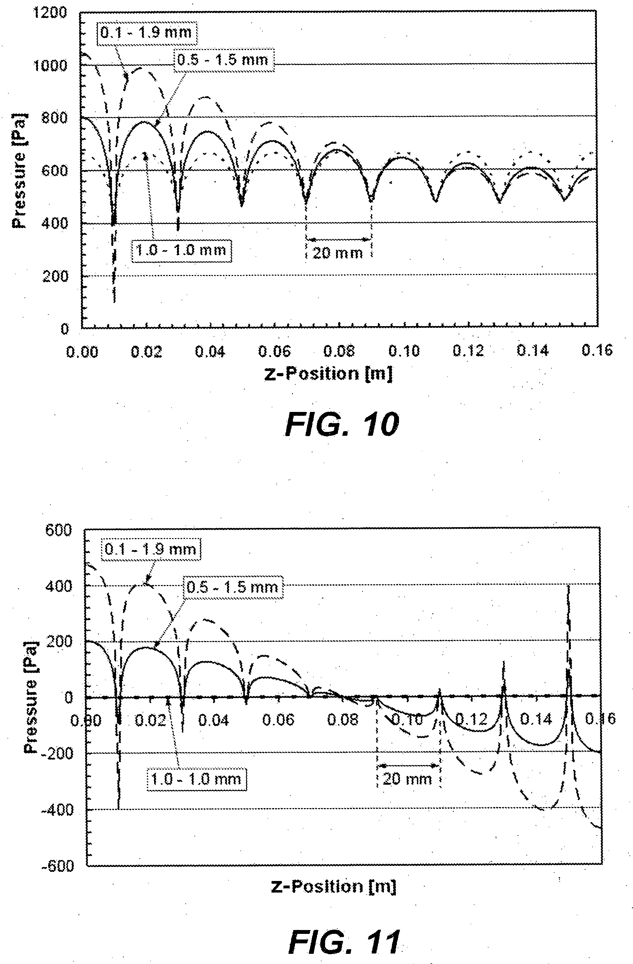

Figs. 9-11 relate to rotational aberrations. Fig. 9 illustrates three physical situations whose data are compared in Figs. 10 and 11. These physical situations correspond to different angular positions of a square 160 mm x 160 mm substrate 140 within the process tunnel 102. In a first situation (top drawing), the longitudinal edges of the substrate 140 are aligned or parallel with the side walls 108 of the tunnel, and the substrate as a whole is symmetrically positioned there between. In a second situation (middle drawing), the substrate 140 has rotated to a position wherein its opposing corners are separated from the side walls 108 of the process tunnel 102 by distances of respectively 0.5 and 1.5 mm. And in a third situation (bottom drawing), the substrate 140 has rotated even further to a position wherein opposing corners are separated from the side walls 108 by distances of 0.1 and 1.9 mm, respectively. The center-to-center distance between adjacent gas exhaust channels 110 in the side walls 108 of the process tunnel 102 measures 20 mm, such that a side wall portion the length of an edge of the substrate 140 comprises 8 (i.e. 160/20) gas exhaust channels.

Fig. 10 illustrates the pressure distribution in the longitudinal gas channel 106 alongside the entire left side of each of the substrates 140 shown in Fig. 9. The pressure distribution exhibits a series of 'pressure bumps', located in between adjacent gas exhaust holes 110. The pressure bumps are 'highest' where the longitudinal gas channel 106 is pinched off the most, and smallest where the longitudinal gas channel 106 is widest. Seen in the positive longitudinal direction (marked 'z' in Fig. 9) the height of the bumps decays for every next pair of gas exhaust channels 110. For the first situation shown in Fig. 9 (i.e. the non-rotated situation), all pressure bumps have the same height.

The left-side pressure distributions shown in Fig. 10 are of course also present on the right side of the substrates 140, albeit that on the, right side they develop in the reverse direction. Subtracting these reverse distributions from those shown in Fig. 10 yields the differential pressure distributions shown in Fig. 11. Since the pressure distribution is symmetrical with respect to the center of the substrate, the resulting effect corresponds to a restoring clockwise force couple. The couple is largest for the substrate 140 in the third (bottom) situation of Fig. 9, somewhat smaller for the substrate in the second (middle) situation shown in said figure, and zero for the substrate in the first (top) situation which, indeed, has not been rotated at all.

The ability of the opposing side walls 108 to provide for a restoring force couple depends on the number of gas exhaust channels 110 distributed along the length of substrate 140. Too few gas exhaust channels 110, and the pressure distribution is not fine enough to effect a gentle restoring force couple at every longitudinal position along the processing track. Too many exhaust channels 110, and there is an insufficient development of highpressure bumps between them. As before, experiments have revealed that a gas exhaust channel density, i.e. the number of gas exhaust channels 110 in a lateral wall 108 present along the length of a longitudinal substrate edge, in the range 5-20 is workable, while an exhaust gas channel density in the range 8-15 is preferred.

As a general measure to enhance the lateral stabilisation of a substrate, and more in particular to increase the magnitude of any correctional forces acting on the substrate, the substrate processing apparatus 100 described above with reference to in particular Figs. 1 and 2 may additionally be provided with a plurality of positioning gas injection channels 123, 133. In a preferred embodiment, these positioning gas injection channels 123, 133 may be disposed in the lower tunnel wall 120 and/or the upper tunnel wall 130, preferably along substantially the entire length of the process tunnel, and be located
(i) seen in a top view: in a gap between a lateral edge of a centered substrate 140 and a respective lateral wall 108 of the process tunnel 102 (such that the positioning gas injection channels 123, 133 inject immediately into a longitudinally extending gas channel 106 (see Fig. 2) that runs alongside a centered wafer), *and*
(ii) seen in the longitudinal direction of the tunnel 120: between successive gas exhaust channels 110.

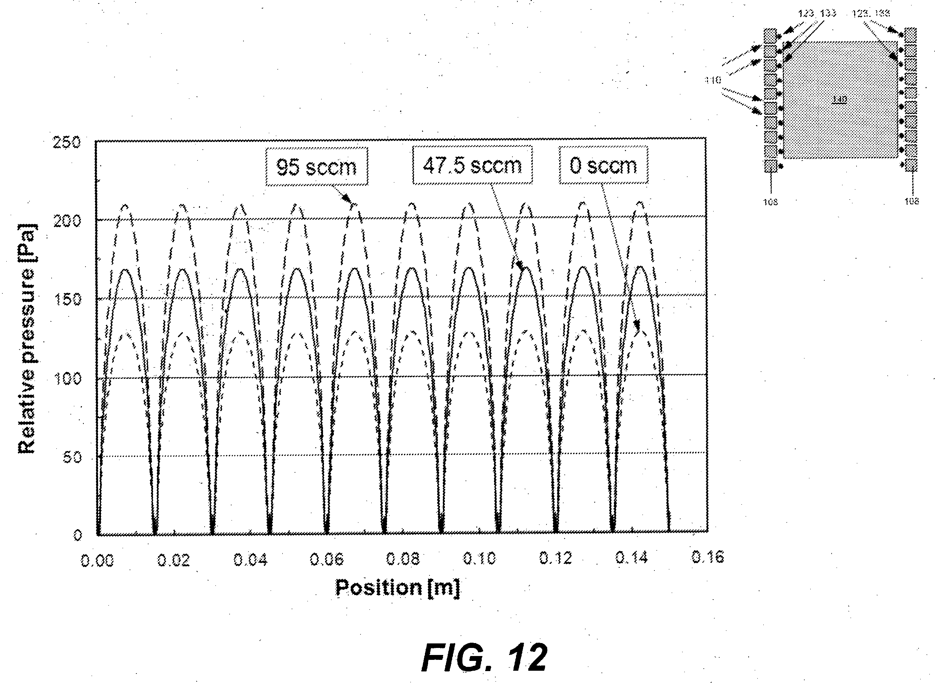

The insert in the top right corner of Fig.12 schematically illustrates these positions of the positioning gas injection channels 123, 133 in a top view, the positions being marked as dots. The positioning gas injection channels 123, 133 may be provided only in the lower tunnel wall 120, only in the upper tunnel wall 130, or in both walls 120, 130. In the latter case, the positioning gas injection channels 122, 123 may preferably be arranged in pairs, wherein the two positioning gas injection channels 122, 123 of a pair are disposed opposite to each other. In an alternative embodiment of the apparatus 100, positioning gas injection channels may not be provided in the lower and/or upper tunnel walls 120, 130, but in the lateral walls 108 of the apparatus 100, in between the gas exhaust channels 110 provided therein. Embodiments with positioning gas injection channels provided in a combination of a lateral wall 108 and a lower and/or upper tunnel wall 120, 130 are also contemplated.

The positioning gas injection channels 123, 133 may be connected to gas sources of an inert positioning gas, such as for example nitrogen, and preferably be controllable independently of the gas injection channels 122, 132. I.e. the gas injection rate of the positioning gas injection channels 123, 133 may preferably be controllable independently of the gas injection rate of the gas injection channels 122, 132. Alternatively, the gas injection rate of the positioning gas injection channels 123, 133 may be fixed relative to the gas injection rate of the gas injection channels 122, 132, which in itself may be controllable. In the case of such a fixed relation between the injection rates, the gas injection rate of the positioning gas injection channels 123, 133 may preferably be configured to be larger than the gas injection rate of the gas injection channels 122, 132. In case at least some of the gas injection channels 122, 132 are configured to inject an inert process gas that may also be used as a positioning gas (e.g. in the case of (purge) gas injection channels 122, 132 in an ALD configuration), a fixed relation between the flow rates of those gas injection channels 122, 132 and the positioning gas injections channels 123, 133 may be effected in an economical fashion, for example by connecting the respective groups of channels to a single (main) inert gas supply conduit by means of conduits having different diameters that reflect the desired injection flow rate ratio.

Fig. 12 illustrates three different pressure distributions that may occur in the longitudinal gas channels alongside the lateral sides of the centered square substrate 140 shown in the insert in the top right corner. The pressure distributions are associated with different injection flow rates of positioning gas: 0 sccm, 47.5 sccm, and 95 sccm, respectively (sccm=standard cubic centimeter per minute). The graph makes it clear that increased positioning gas injection flow rates correspond to higher 'pressure bumps' between the gas exhaust channels 110, which in this example are spaced 15mm apart. Since higher pressure bumps result in larger correctional forces on the substrate 140 in case it strays from its ideal position or orientation, the injection of positioning gas enhances the operation of the lateral stabilization mechanism.

Although illustrative embodiments of the present invention have been described above, in part with reference to the accompanying drawings, it is to be understood that the invention is not limited to these embodiments. Variations to the disclosed embodiments can be understood and effected by those skilled in the art in practicing the invention, defined in the appended claims. Reference throughout this specification to "one embodiment" or "an embodiment" means that a particular feature, structure or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, it is noted that particular features, structures, or characteristics of one or more embodiments may be combined in any suitable manner to form new, not explicitly described embodiments.

### List of elements

- 100: atomic layer deposition apparatus
- 102: process tunnel
- 104: process tunnel space
- 106: longitudinal gas channel adjacent side wall
- 108: lateral wall of process tunnel
- 110: gas exhaust channel
- 112: gas exhaust conduit
- 114: tunnel segment comprising four laterally extending gas zones

- 120: lower tunnel wall
- 122: gas injection channels in lower tunnel wall
- 123: positioning gas injection channel in lower tunnel wall
- 124: lower gas bearing

- 130: upper tunnel wall
- 132: gas injection channels in upper tunnel wall
- 133: positioning gas injection channel in upper tunnel wall
- 134: upper gas bearing

- 140: substrate
- 140a,b: lower surface (a) or upper surface (b) of substrate

- T: transport direction of process tunnel

## Claims

1. A method comprising:
- providing a substrate processing apparatus (100) comprising:
o a process tunnel (102), said process tunnel including a lower tunnel wall (120), an upper tunnel wall (130), and two lateral tunnel walls (108), wherein said tunnel walls together bound a process tunnel space (104) that extends in a transport direction (T) and that is configured to accommodate at least one substantially planar substrate (140) that is oriented parallel to the upper and lower tunnel walls;
o a plurality of gas injection channels (122, 132), provided in both the lower and the upper tunnel wall, wherein the gas injection channels in the lower tunnel wall are configured to provide for a lower gas bearing (124), while the gas injection channels in the upper tunnel wall are configured to provide for an upper gas bearing (134), said gas bearings being configured to floatingly support and accommodate said substrate there between;
**characterized in that** the method further comprises:
- providing a substantially rectangular substrate and transporting it through the process tunnel in said transport direction (T); and **in that**
- the provided semiconductor processing apparatus further comprises a plurality of gas exhaust channels (110), provided in both said lateral tunnel walls (108), wherein the gas exhaust channels in each lateral tunnel wall are spaced apart in the transport direction, and wherein a gas exhaust channel density, i.e. a number of gas exhaust channels (110) in said lateral tunnel walls (108) per unit of tunnel length, which unit of tunnel length is equal to a length of the substrate, is in the range of 5-20.

2. The method according to claim 1, wherein the gas exhaust channel density in both said lateral tunnel walls is in the range 8-15 along at least a portion of their lengths.

3. The method according to any of the claims 1-2, wherein any two neighboring gas exhaust channels (110) of the plurality of gas exhaust channels provided in a said lateral tunnel wall (108) are spaced apart by at least 75% of their center-to-center distance.

4. The method according to any of the claims 1-3, wherein the gas exhaust channels (110) in a said lateral tunnel wall (108) are equidistantly spaced apart.

5. The method according to any of the claims 1-4, wherein the gas exhaust channels (110) in said lateral tunnel walls (108) are opposingly disposed, such that each gas exhaust channel of the plurality of exhaust channels provided in one of said lateral tunnel walls faces a corresponding exhaust channel of the plurality of exhaust channels provided in the other of said lateral tunnel walls.

6. The method according to any of the claims 1-5, wherein the center-to-center distance between two neighboring gas exhaust channels (110) in a said lateral tunnel wall (108) is in the range 10-30 mm.

7. The method according to any of the claims 1-6, wherein the gas exhaust channels (110) have an effective cross-sectional area in the range of 0.25-2 mm².

8. The method according to any of the claims 1-7, wherein the process tunnel space (104) is 0.5-3 mm wider than the substrates (140) to be processed therein.

9. The method according to any of the claim 1-8, wherein gas injection channels (122, 132) in at least one of the lower wall (120) and the upper wall (130), viewed in the transport direction (T), are successively connected to a first precursor gas source, a purge gas source, a second precursor gas source and a purge gas source, so as to create a process tunnel segment (114) that - in use - comprises successive zones including a first precursor gas, a purge gas, a second precursor gas and a purge gas, respectively, and wherein at least two of such tunnel segments are disposed in succession in the transport direction.

10. The method according to any of the claims 1-9, further comprising heating means configured to heat gas to a suitable temperature before said gas is injected into the tunnel space (104) by the gas injection channels (132, 122) provided in said upper (130) or lower (120) tunnel wall.

11. The method according to any of the claims 1-10, wherein the semiconductor processing appparatus (100) further comprising a plurality of positioning gas injection channels (123, 133), provided in the upper and/or lower tunnel wall (120, 130) and disposed
(i) seen in a top view of the apparatus with a centered substrate therein: in a gap between a lateral edge of the substrate (140) and a respective lateral wall (108) of the process tunnel (102), and
(ii) seen in the longitudinal direction of the tunnel 120: between successive gas exhaust channels 110,
wherein said positioning gas injection channels are configured to inject an inert positioning positioning gas, such as nitrogen.

12. The method according to claim 11, wherein the positioning gas injection channels (123, 133), seen in a top view of the apparatus (100), are disposed within 1.5mm from the respective lateral wall (108).

13. The method according to claim 11 or 12, wherein the positioning gas injection channels (123, 133) are configured to inject positioning gas at a flow rate that is larger than a flow rate at which gas is configured to be injected from the gas injection channels (122, 132).

## Patentansprüche

1. Verfahren, umfassend:
- die Bereitstellung einer substratverarbeitenden Vorrichtung (100), umfassend:
o einen Verarbeitungstunnel (102) mit einer unteren Tunnelwand (120), einer oberen Tunnelwand (130) und zwei seitlichen Tunnelwänden (108), wobei die Tunnelwände zusammen einen Verarbeitungstunnelraum (104) begrenzen, der in einer Transportrichtung (T) verläuft und der konfiguriert ist, um mindestens ein im Wesentlichen ebenes Substrat (140) aufzunehmen, das parallel zu den oberen und unteren Tunnelwänden ausgerichtet ist;
o mehrere Gaseinspritzkanäle (122, 132), bereitgestellt in den beiden unteren und oberen Tunnelwänden, wobei die Gaseinspritzkanäle in der unteren Tunnelwand zur Bereitstellung eines unteren Gaslagers (124) konfiguriert sind, während die Gaseinspritzkanäle in der oberen Tunnelwand zur Bereitstellung eines oberen Gaslagers (134) konfiguriert sind, wobei die Gaslager konfiguriert sind, um schwebend das Substrat zwischen Ihnen zu tragen und aufzunehmen;
**dadurch gekennzeichnet, dass** das Verfahren ferner umfasst:
- die Bereitstellung eines im Wesentlichen rechteckigen Substrats und dessen Transport durch den Verarbeitungstunnel in der Transportrichtung (T); und dadurch dass
- die bereitgestellte Halbleiter-Verarbeitungsvorrichtung ferner mehrere Gasabzugskanäle (110) umfasst, bereitgestellt in beiden der seitlichen Tunnelwände (108), wobei die Gasabzugskanäle in jeder seitlichen Tunnelwand in einem Abstand voneinander in Transportrichtung sind und wobei eine Gasabzugskanaldichte, d. h., eine Anzahl von Gasabzugskanälen (110) in den seitlichen Tunnelwänden (108) pro Einheit Tunnellänge, die gleich einer Länge des Substrats ist, im Bereich von 5-20 ist.

2. Verfahren nach Anspruch 1, wobei die Gasabzugskanaldichte in beiden seitlichen Tunnelwänden im Bereich von 8-15 entlang mindestens eines Abschnitts ihrer Längen ist.

3. Verfahren nach einem der Ansprüche 1-2, wobei beliebige zwei benachbarte Gasabzugskanäle (110) der mehreren Gasabzugskanäle, bereitgestellt in den seitlichen Tunnelwänden (108), in einem Abstand von mindestens 75 % ihres Mitte-Mitte-Abstands sind.

4. Verfahren nach einem der Ansprüche 1-3, wobei die Gasabzugskanäle (110) in den seitlichen Tunnelwänden (108) in einem gleichen Abstand voneinander sind.

5. Verfahren nach einem der Ansprüche 1-4, wobei die Gasabzugskanäle (110) in den seitlichen Tunnelwänden (108) gegenüber angeordnet sind, sodass jeder Gasabzugskanal der mehreren Gasabzugskanäle, bereitgestellt in den seitlichen Tunnelwänden, einem entsprechenden Abzugskanal der mehreren Abzugskanäle, bereitgestellt in der anderen der seitlichen Tunnelwände, gegenüberliegt.

6. Verfahren nach einem der Ansprüche 1-5, wobei der Mitte-Mitte-Abstand zwischen zwei benachbarten Gasabzugskanälen (110) in den seitlichen Tunnelwänden (108) im Bereich von 10-30 mm ist.

7. Verfahren nach einem der Ansprüche 1-6, wobei die Gasabzugskanäle (110) eine effektive Querschnittsfläche im Bereich von 0,25-2 mm² haben.

8. Verfahren nach einem der Ansprüche 1-7, wobei der Verarbeitungstunnelraum (104) 0,5-3 mm breiter ist als die darin zu verarbeitenden Substrate (140).

9. Verfahren nach einem der Ansprüche 1-8, wobei Gaseinspritzkanäle (122, 132) in mindestens einer der unteren Wand (120) und der oberen Wand (130), gesehen in Transportrichtung (T) nacheinander verbunden sind mit einer ersten Vorläufergasquelle, einer Reinigungsgasquelle, einer zweiten Vorläufergasquelle und einer Reinigungsgasquelle, um ein Verarbeitungstunnelsegment (114) zu schaffen, das - bei Verwendung - aufeinanderfolgende Zonen umfasst, die jeweils ein erstes Vorläufergas, ein Reinigungsgas, ein zweites Vorläufergas und ein Reinigungsgas enthalten, und wobei mindestens zwei solcher Tunnelsegmente in Folge in der Transportrichtung angeordnet sind.

10. Verfahren nach einem der Ansprüche 1-9, ferner umfassend Heizmittel, konfiguriert zum Erwärmen von Gas auf eine geeignete Temperatur, bevor das Gas in den Tunnelraum (104) durch die Gaseinspritzkanäle (132, 122), bereitgestellt in der oberen (130) oder unteren (120) Tunnelwand eingespritzt wird.

11. Verfahren nach einem der Ansprüche 1-10, wobei die Halbleiter-Verarbeitungsvorrichtung (100) mehrere positionierende Gaseinspritzkanäle (123, 133), bereitgestellt in der oberen und/oder unteren Tunnelwand (120, 130) umfasst, angeordnet
(i) gesehen in einer Draufsicht der Vorrichtung mit darin einem zentrierten Substrat: in einer Lücke zwischen einem seitlichen Rand des Substrats (140) und einer entsprechenden seitlichen Wand (108) des Verarbeitungstunnels (102), und
(ii) gesehen in Längsrichtung des Tunnels 120: zwischen aufeinanderfolgenden Gasabzugskanälen (110),
wobei die positionierenden Gaseinspritzkanäle zum Einspritzen eines inerten positionierenden Gases, wie etwa Stickstoff, konfiguriert sind.

12. Verfahren nach Anspruch 11, wobei die positionierenden Gaseinspritzkanäle (123, 133), gesehen in einer Draufsicht der Vorrichtung (100), innerhalb von 1,5 mm von der jeweiligen Seitenwand (108) angeordnet sind.

13. Verfahren nach Anspruch 11 oder 12, wobei die positionierenden Gaseinspritzkanäle (123, 133) konfiguriert sind, um positionierendes Gas bei einer Flussrate, die größer ist als eine Flussrate, bei der Gas konfiguriert ist, um aus den Gaseinspritzkanälen (122, 132) eingespritzt zu werden, einzuspritzen.

## Revendications

1. Procédé comprenant :
- la fourniture d'un appareil de traitement de substrat (100) comprenant :
- un tunnel de traitement (102), ledit tunnel de traitement comprenant une paroi de tunnel inférieure (120), une paroi de tunnel supérieure (130), et deux parois de tunnel latérales (108), dans lequel lesdites parois de tunnel délimitent, ensemble, un espace de tunnel de traitement (104) qui s'étend dans une direction de transport (T) et qui est configuré pour loger au moins un substrat (140) sensiblement plan qui est orienté parallèlement aux parois de tunnel supérieure et inférieure ;
- une pluralité de canaux d'injection de gaz (122, 132), prévus à la fois dans les parois de tunnel inférieure et supérieure, dans lequel les canaux d'injection de gaz dans la paroi de tunnel inférieure sont configurés pour réaliser un palier de gaz inférieur (124), tandis que les canaux d'injection de gaz dans la paroi de tunnel supérieure sont configurés pour réaliser un palier de gaz supérieur (134), lesdits paliers de gaz étant configurés pour supporter et loger de manière flottante ledit substrat entre eux ;
**caractérisé en ce que** le procédé comprend en outre :
- la fourniture d'un substrat sensiblement rectangulaire et son transport à travers le tunnel de traitement dans ladite direction de transport (T) ; et **en ce que**
- l'appareil de traitement de semi-conducteur fourni comprend en outre une pluralité de canaux d'évacuation de gaz (110), prévus dans lesdites deux parois de tunnel latérales (108), dans lequel les canaux d'évacuation de gaz dans chaque paroi de tunnel latérale sont espacés dans la direction de transport, et dans lequel une densité de canaux d'évacuation de gaz, c'est-à-dire un nombre de canaux d'évacuation de gaz (110), dans lesdites parois de tunnel latérales (108) par unité de longueur de tunnel, laquelle unité de longueur de tunnel est égale à une longueur du substrat, est dans la plage de 5 à 20.

2. Procédé selon la revendication 1, dans lequel la densité de canaux d'évacuation de gaz dans lesdites deux parois de tunnel latérales est dans la plage de 8 à 15 le long d'au moins une partie de leurs longueurs.

3. Procédé selon l'une quelconque des revendications 1 et 2, dans lequel deux canaux d'évacuation de gaz (110) quelconques voisins de la pluralité de canaux d'évacuation de gaz prévus dans une dite paroi de tunnel latérale (108) sont espacés d'au moins 75 % de leur distance centre à centre.

4. Procédé selon l'une quelconque des revendications 1 à 3, dans lequel les canaux d'évacuation de gaz (110) dans une dite paroi de tunnel latérale (108) sont espacés de manière équidistante.

5. Procédé selon l'une quelconque des revendications 1 à 4, dans lequel les canaux d'évacuation de gaz (110) dans lesdites parois de tunnel latérales (108) sont disposés de manière opposée, de sorte que chaque canal d'évacuation de gaz de la pluralité de canaux d'évacuation prévus dans l'une desdites parois de tunnel latérales soit face à un canal d'évacuation correspondant de la pluralité de canaux d'évacuation prévus dans l'autre desdites parois de tunnel latérales.

6. Procédé selon l'une quelconque des revendications 1 à 5, dans lequel la distance centre à centre entre deux canaux d'évacuation de gaz (110) voisins dans une dite paroi de tunnel latérale (108) est dans la plage de 10 à 30 mm.

7. Procédé selon l'une quelconque des revendications 1 à 6, dans lequel les canaux d'évacuation de gaz (110) ont une section transversale efficace dans la plage de 0,25 à 2 mm².

8. Procédé selon l'une quelconque des revendications 1 à 7, dans lequel l'espace de tunnel de traitement (104) est plus large de 0,5 à 3 mm que les substrats (140) à traiter dans celui-ci.

9. Procédé selon l'une quelconque des revendications 1 à 8, dans lequel les canaux d'injection de gaz (122, 132) dans au moins l'une de la paroi inférieure (120) et de la paroi supérieure (130), vus dans la direction de transport (T), sont reliés successivement à une première source de gaz précurseur, une source de gaz de purge, une deuxième source de gaz précurseur et une source de gaz de purge, de manière à créer un segment de tunnel de traitement (114) qui - en utilisation - comprend des zones successives comprenant un premier gaz précurseur, un gaz de purge, un deuxième gaz précurseur et un gaz de purge, respectivement, et dans lequel au moins deux de ces segments de tunnel sont disposés successivement dans la direction de transport.

10. Procédé selon l'une quelconque des revendications 1 à 9, comprenant en outre des moyens de chauffage configurés pour chauffer le gaz à une température appropriée avant que ledit gaz soit injecté dans l'espace de tunnel (104) par les canaux d'injection de gaz (132, 122) prévus dans ladite paroi de tunnel supérieure (130) ou inférieure (120).

11. Procédé selon l'une quelconque des revendications 1 à 10, dans lequel l'appareil de traitement de semi-conducteur (100) comprend en outre une pluralité de canaux d'injection de gaz de positionnement (123, 133), prévus dans la paroi de tunnel supérieure et/ou inférieure (120, 130) et disposés
(i) vus dans une vue du dessus de l'appareil avec un substrat centré dans celui-ci : dans un espace entre un bord latéral du substrat (140) et une paroi latérale (108) respective du tunnel de traitement (102), et
(ii) vus dans la direction longitudinale du tunnel (120) : entre des canaux d'évacuation de gaz (110) successifs,
dans lequel lesdits canaux d'injection de gaz de positionnement sont configurés pour injecter un gaz de positionnement inerte, tel que de l'azote.

12. Procédé selon la revendication 11, dans lequel les canaux d'injection de gaz de positionnement (123, 133), vus dans une vue du dessus de l'appareil (100), sont disposés dans les limites de 1,5 mm de la paroi latérale (108) respective.

13. Procédé selon la revendication 11 ou 12, dans lequel les canaux d'injection de gaz de positionnement (123, 133) sont configurés pour injecter le gaz de positionnement à un débit qui est supérieur à un débit auquel le gaz est configuré pour être injecté à partir des canaux d'injection de gaz (122, 132).
